# EUROPEAN PATENT APPLICATION

(11) **EP 1 912 262 A1**
(43) Date of publication of application: **16.04.2008**
(21) Application number: 06381036.0
(22) Date of filing: 18.09.2006
(51) Int. Cl.: H01L 31/052

(54) **Thermoregulatory system for a photovoltaic module**

(71) Applicant: Linkpoint Europe, 33003 Oviedo (ES)
(72) Inventor: Gutierrez Canseco, Juan, 33003 Oviedo (ES)
(74) Representative: Esteban Perez-Serrano, Maria Isabel

(57) **Abstract**

The object of the present invention is a photovoltaic module thermoregulatory system which enables the operating temperature of the photovoltaic cells to be lowered in the installations connected to a network, where due to this drop in temperature the efficiency of the photovoltaic modules rises when the operating temperature of the photovoltaic cells comes into line with the optimum working temperature and, consequently, the electric energy generated by the photovoltaic installation is increased by means of a spray of atomized water, which evaporates due to the higher temperature of the air circulating along channels posterior to the photovoltaic cells.

## Description

### OBJECT OF THE INVENTION

The object of the present invention is a photovoltaic module thermoregulatory system which enables the operating temperature of the photovoltaic cells in the installations connected to a network to be lowered.

Owing to this lowering of temperature, the efficiency of the photovoltaic modules rises as the optimum operating temperature of the photovoltaic cells approaches the optimum working temperature and the electric energy generated by the photovoltaic installation increases accordingly.

To obtain this lowering of the temperature, at the photovoltaic module input there is a spray of atomized water which evaporates due to the higher temperature of the air circulating along channels posterior to the photovoltaic cells, so that that the air, in turn, lowers its temperature and, therefore, that of the photovoltaic cells.

### BACKGROUND OF THE INVENTION

Photovoltaic modules made up of a set of cells, photovoltaic cells, which produce electricity from the light falling on them, are only too familiar in the state of the art.

On a sunny day, the sun irradiates around 1 KW/m² on the surface of the earth but current photovoltaic panels only have an average efficiency of 12-15%, from which an output of approximately 120-150 W/m² is obtained. However, not all days are sunny, so the effective yield is lower.

The amperage generated by the panel increases with radiation, while the voltage remains approximately constant. In this respect, the placement of the panels plays an important role, i.e. their orientation and inclination in respect of the horizontal, as the radiation values vary in the course of the day depending on the inclination of the sun in relation to the horizon.

Temperature rise in the photovoltaic cells means an increase in current, but at the same time a proportionally much greater decrease in voltage, as the power curve presents a greater absolute gradient on the voltage axis.

The global effect is that the power of the panel, and associated with this the efficiency, decreases when its working temperature rises.

The photovoltaic module thermoregulatory system of the present invention brings the operating temperature of the photovoltaic cells into line with the optimum working temperature and as a result the electric energy generated by the photovoltaic installation increases.

### DESCRIPTION OF THE INVENTION

The present invention refers to a photovoltaic module thermoregulatory system that enables the operating temperature of the photovoltaic cells to be reduced in installations connected to a network.

The thermoregulatory system is composed of three parts: a water supply system, a diffuser, and an air extraction system.

The water supply system presents a series of conduits that start out from a sealed tank, together with a compressor regulated by a control system.

The conduits give onto various pipes which are joined to the bottom of the diffuser and at this junction end they have a series of valves.

The diffuser is a metallic piece with one concave side and therefore another convex one, which is faced by the concave side at the rear side of the photovoltaic panel, so that a ventilation duct is created between both, divided into parts by means of rubber bands, which create a series of channels for the flow of the air.

The extraction system may be natural or passive and it is in the upper part of the diffuser for the air outlet.

As of a given temperature detected in the photovoltaic panel, the control system activates the compressor, whereby the water in the tank is pressurized so that, when a setpoint pressure is reached, the valves open and force out the atomized water towards the bottom of the panel and the diffuser captures the water vapour at the start of the ventilation duct.

In this way, the evaporation of the atomized water in the channels upon coming into contact with the air lowers the temperature of the air along the channels and therefore reduces the temperature of the areas heated by the cells of the photovoltaic panel and of the actual cells, thereby increasing the efficiency of the panel.

The system, therefore, creates an environment where to induce and control the heat absorbed by the combination of retro-evaporation of the water and ventilation on the part of the air.

### DESCRIPTION OF THE DRAWINGS

The present report is supplemented with a set of drawings, illustrative of the preferred example of embodiment and never restrictive of the invention.

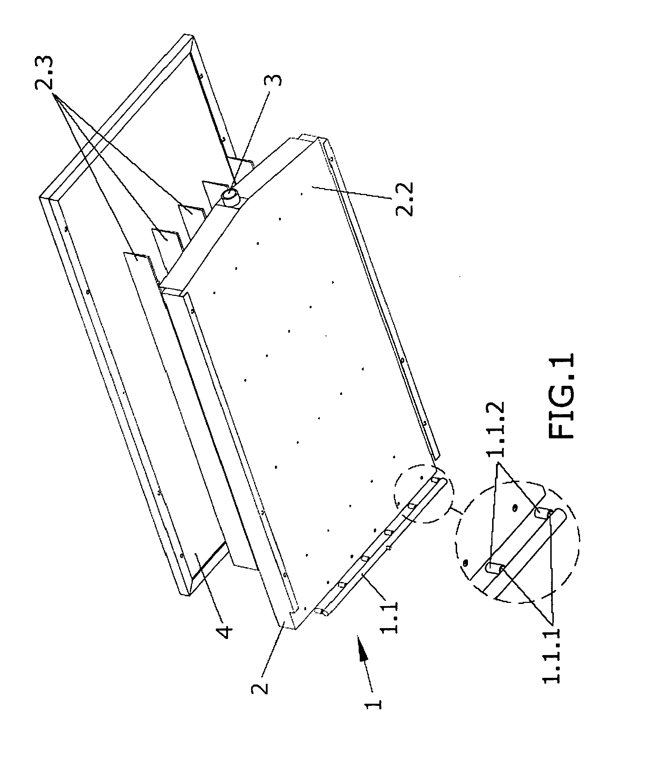

Figure 1 shows an exploded view of an embodiment of the invention, where we observe the photovoltaic module thermoregulatory system with a passive extraction system.

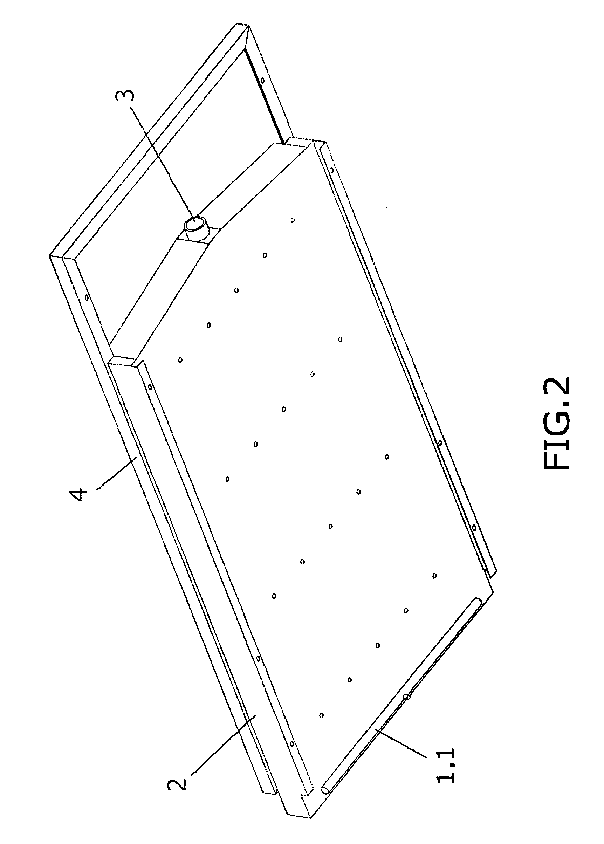

Figure 2 shows a perspective view of an embodiment of the invention, where we observe the photovoltaic module thermoregulatory system with a passive extraction system.

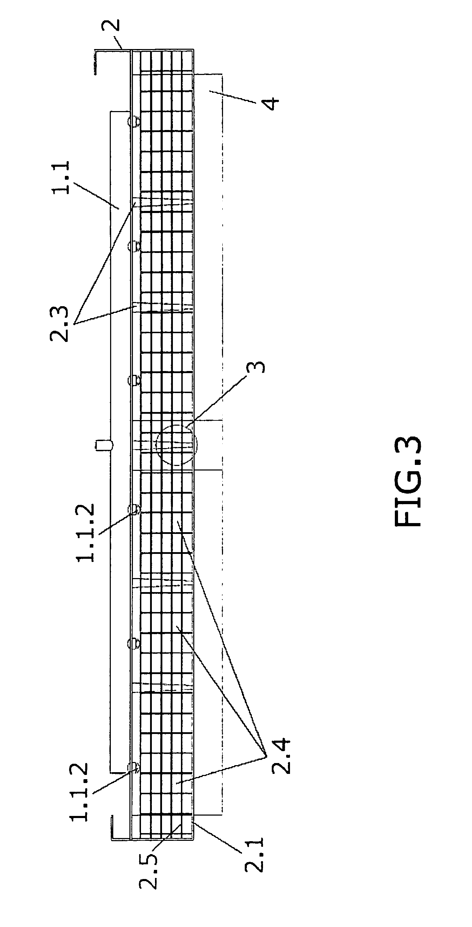

Figure 3 shows an elevational view of an embodiment of the invention, where we observe photovoltaic module thermoregulatory system with a passive extraction system.

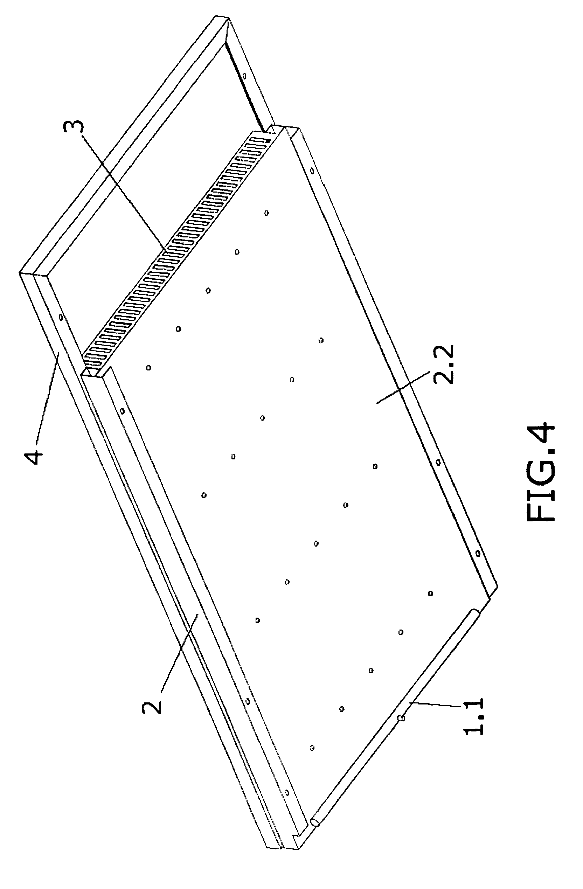

Figure 4 shows a perspective view of an embodiment of the invention, where we observe the photovoltaic module thermoregulatory system with a natural extraction system.

### PREFERRED EMBODIMENT OF THE INVENTION

In the light of the foregoing, the present invention refers to a photovoltaic module thermoregulatory system that brings the operating temperature of the photovoltaic cells into line with the optimum working temperature and, as a result, the electric energy generated by the photovoltaic installation is increased.

### First example of preferred embodiment

The thermoregulatory system is composed of three parts, a water supply system (1), a diffuser (2), and an air extraction system (3).

The water supply system (1) presents a series of conduits (1.1) which start out from a sealed tank together with a compressor regulated by a control system (not shown in the figures).

Each one of the conduits (1.1) splits up into a number of tubes (1.1.1), which are joined to the diffuser (2) on its underside and at this junction end they have a series of valves (1.1.2).

The diffuser (2) is a metallic piece which is prolonged on its larger sides by means of two perpendicular extensions, so that one concave side (2.1) and, therefore, another convex side (2.2) are defined.

On the concave side (2.1) the diffuser (2) is facing the rear side of the photovoltaic panel (4), so that a ventilation duct is created between both, divided into parts by means of rubber bands (2.3) that create a series of channels (2.4) for the flow of air.

The air extraction system (3) is passive and consists of a chimney, which is located at the top part of the air outlet diffuser (2).

During sunlight hours, the extraction system (3) creates a convection current of rising air along the channels (2.4) due to the difference in pressure created by the chimney, which is at a higher temperature.

The control system activates the compressor as of a given temperature detected at the photovoltaic panel (4) or in the environment, whereby the water in the tank is pressurized, so that when a setpoint pressure is reached, the valves (1.1.2) open and eject atomized water towards the lower portion of the photovoltaic panel (4) and the diffuser (2) captures the water vapour at the start of the channels (2.4).

In this way, the evaporation of the atomized water in the channels (2.4), upon coming into contact with the air, reduces the temperature of the air passing along the channels (2.4) and therefore lowers the temperature of the areas heated up by the cells of the photovoltaic panel (4) and of the actual cells, thereby boosting the efficiency of the photovoltaic panel (4).

The diffuser (2) also has a metal grid (2.5) in the vaporization areas of the channels (2.4), where part of the vapour is condensed and acts as another heat exchange element.

### Second example of preferred embodiment

In this second example of preferred embodiment the water supply system (1) and the diffuser present the same configuration as in the first example of preferred embodiment.

The air extraction system (3) is natural, as the upper area of the channels (2.4) presents an air outlet grille.

In this second example of preferred embodiment the control system activates the compressor by means of a timer, whereby the water in the tank is pressurized, so that when a setpoint pressure is reached, the valves (1.1.2) open and eject atomized water in the direction of the lower portion of the photovoltaic panel (4) and the diffuser (2) captures the water vapour at the start of the channels (2.4).

Focusing the essence of the invention, this refers to a photovoltaic module thermoregulatory system characterised in that in the photovoltaic module there is a spray of atomized water, which is evaporated due to the higher temperature of the air circulating along channels (2.4) posterior to the cells of the photovoltaic panel (4) and present in a diffuser (2), so that that air in turn lowers its temperature and, therefore, brings the operating temperature of the photovoltaic cells into line with the optimum working temperature and, consequently, the electric energy generated by the photovoltaic installation is stepped up.

The essential nature of this invention is not altered by variations in materials, shape, size and arrangement of the component elements, described in a non-restrictive manner but which suffices for it to be reproduced by an expert.

## Claims

1. Photovoltaic module thermoregulatory system **characterised in that** in the photovoltaic module there is a spray of atomized water which evaporates due to the higher temperature of the air circulating along channels (2.4) posterior to the cells of the photovoltaic panel (4) and present in a diffuser (2), in such a way that that air in turn lowers its temperature and, consequently, brings the operating temperature of the photovoltaic cells into line with the optimum working temperature and, as a result, the electric energy generated by the photovoltaic installation is increased.

2. Photovoltaic module thermoregulatory system according to claim 1 **characterised in that** at the intake the diffuser presents a water supply system (1) and at the outlet an air extraction system (3).

3. Photovoltaic module thermoregulatory system according to claim 2 **characterised in that** the water supply system (1) presents a series of conduits (1.1) that start out from a sealed tank, together with a compressor governed by a control system, where each one of the conduits (1.1) splits into a number of tubes (1.1.1) that are joined to the diffuser (2) on its underside and at that junction end they have a series of valves (1.1.2).

4. Photovoltaic module thermoregulatory system according to claim 3 **characterised in that** the control system activates the compressor as of a given temperature detected at the photovoltaic panel (4) or in the environment, whereby the water in the tank is pressurized, so that when a setpoint temperature is reached, the valves (1.1.2) open and eject atomized water in the direction of the lower portion of the photovoltaic panel (4) and the diffuser (2) captures the water vapour at the start of the channels (2.4).

5. Photovoltaic module thermoregulatory system according to claim 3 **characterised in that** the control system activates the compressor by means of a timer, whereby the water in the tank is pressurized, so that when a setpoint temperature is reached, the valves (1.1.2) open and eject atomized water in the direction of the lower portion of the photovoltaic panel (4) and the diffuser (2) captures the water vapour at the start of the channels (2.4).

6. Photovoltaic module thermoregulatory system according to claim 1 **characterised in that** the diffuser (2) is a metallic piece that is prolonged on its larger sides by means of two perpendicular extensions, such that one concave side (2.1) and, therefore, another convex side (2.2) are defined.

7. Photovoltaic module thermoregulatory system according to claim 6 **characterised in that** on the concave side (2.1) the diffuser (2) is facing the rear side of the photovoltaic panel (4), so that between both a ventilation duct is created, divided into parts by means of rubber bands (2.3), which create channels (2.4) for the flow of air.

8. Photovoltaic module thermoregulatory system according to claim 2 **characterised in that** the air extraction system (3) is passive and consists of a chimney that is located at the upper part of the diffuser (2) for the air outlet.

9. Photovoltaic module thermoregulatory system according to claim 1 **characterised in that** during sunlight hours the extraction system (3) creates a convection current of rising air along the channels (2.4) due to the difference in pressure created by the chimney, which is at a higher temperature.

10. Photovoltaic module thermoregulatory system according to claim 2 **characterised in that** air extraction system (3) is natural, as the upper end of the channels (2.4) presents an air outlet grille.

11. Photovoltaic module thermoregulatory system according to claim 1 **characterised in that** the diffuser (2) presents a metallic grid (2.5) in the vaporization area of the channels (2.4), where part of the vapour is condensed and acts as another heat exchange element.
